# EUROPÄISCHE PATENTSCHRIFT

(11) **EP 0 406 764 B1**
(45) Veröffentlichungstag und Bekanntmachung des Hinweises auf die Patenterteilung: **09.11.1994**
(21) Anmeldenummer: 90112596.3
(22) Anmeldetag: 02.07.1990
(51) Int. Cl.: G01R 1/073

(54) **Adaptiervorrichtung zur Prüfung von filmmontierten integrierten Bausteinen**
Adapter for testing integrated circuits mounted on a film
Adaptateur pour tester des circuits intégrés montés sur une pellicule

(30) Priorität: 07.07.1989 DE 8908326 U
(43) Veröffentlichungstag der Anmeldung: 09.01.1991
(73) Patentinhaber: Siemens Nixdorf Informationssysteme Aktiengesellschaft, 33102 Paderborn (DE)
(72) Erfinder: Ernstberger, Johann, D-8000 München 82 (DE); Wessely, Hermann, D-8000 München 60 (DE)
(74) Vertreter: Fuchs, Franz-Josef, Dr.-Ing.

(56) Entgegenhaltungen:
- EP-A- 0 142 119
- DE-A- 3 312 436
- DE-C- 3 637 406
- US-A- 4 488 111
- US-A- 4 757 256

## Beschreibung

Die Erfindung betrifft eine Adaptiervorrichtung mit einer eine Prüfanschlußplatte mit gefederten Kontaktnadeln enthaltenden Prüfeinrichtung und mit auf einem Film aufgebrachten, zu prüfenden integrierten Bausteinen.

Zur Prüfung von filmmontierten integrierten Schaltkreisen werden Prüfvorrichtungen verwendet, die eine kompliziert ausgebildete Prüfanschlußplatte, die als Mehrlagenleiterplatte ausgeführt ist, aufweisen und deren Anschlußklemmen in einem für die Prüfung geeigneten Rasterabstand angeordnet sind.

Demgegenüber ist der Rasterabstand der Anschlüsse der filmmontierten integrierten Bausteine wesentlich kleiner, so daß ein unmittelbarer Anschluß der Bausteinanschlüsse an die Anschlüsse der Prüfeinrichtung nicht möglich ist.

Die US-Patentschrift US-A-4 757 256 beschreibt eine Adaptiervorrichtung, die eine Leiterplatte mit vom Zentrum dieser Leiterplatte nach außen verlaufenden Leiterbahnen zeigt, wobei die Leiterbahnenden im Zentrum dieser Leiterplatte feststehende, diese Leiterplatte durchdringende Kontaktnadeln aufweisen.

Aufgabe der vorliegenden Erfindung ist es, eine Adaptiervorrichtung zu schaffen, durch die die Prüfung von filmmontierten integrierten Bausteinen mit kleinem Rastermaß in einfacher Weise mit den üblichen Prüfeinrichtungen möglich ist.

Zur Lösung dieser Aufgabe wird gemäß der Erfindung die Adaptiervorrichtung derart ausgebildet, daß zur Adaptierung der Bausteine mit der Prüfanschlußplatte der Prüfeinrichtung eine Zwischenleiterplatte mit vom Zentrum dieser Zwischenleiterplatte auffächernd nach außen verlaufenden Leiterbahnen vorhanden ist, wobei die Rasterabstände im Zentrum der Zwischenleiterplatte den Rasterabständen der Bausteinanschlüsse und die Rasterabstände an der Peripherie der Zwischenleiterplatte den Rasterabständen der Anschlüsse auf der Prüfanschlußplatte entsprechen, daß die Leiterbahnden im Zentrum der Zwischenleiterplatte feststehende, die Zwischenleiterplatte durchdringende Kontaktnadeln aufweisen, daß die Bausteinanschlüsse mit Hilfe von gefederten Stempeln an die feststehenden Kontaktnadeln andrückbar sind und die gefederten Kontaktnadeln der Prüfanschlußplatte die Kontaktstellen an der Peripherie der Zwischenleiterplattenunterseite kontaktieren.

In weiterer Ausgestaltung sieht die Erfindung vor, die integrierten Bausteine auf dem Rücken liegend mit der Zwischenleiterplatte zu kontaktieren und unterhalb der Bausteine eine Kühleinrichtung vorzusehen.

Durch diese Maßnahmen wird erreicht, daß in einfacher Weise die Prüfung filmmontierter integrierter Bausteine (Mikropacks) mit den vorhandenen Prüfeinrichtungen erfolgen kann. Die Zwischenleiterplatte kann dabei mehrfach verwendet werden und muß nur bei einer bestimmten Prüfzyklenanzahl gegen eine neue ausgetauscht werden. Dadurch wird auch der Verschleiß der gefederten Kontaktnadeln der Prüfanschlußplatte wesentlich verringert.

Durch die Einführung der Zwischenleiterplatte kann die Grobstruktur des Leiterbildes in der Prüfanschlußplatte beibehalten werden, wodurch sich die Herstellung dieser kompliziert aufgebauten, großflächigen Platine vereinfacht.

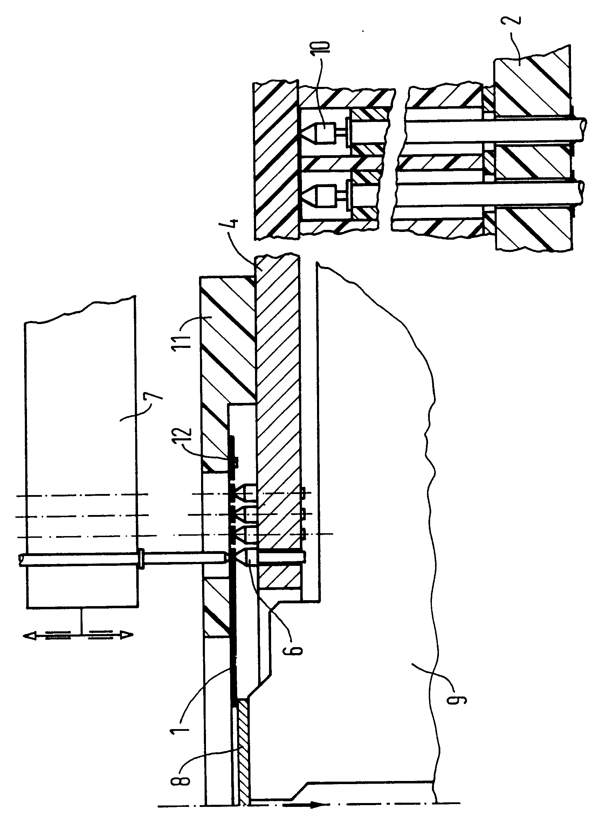

Anhand des Ausführungsbeispiels nach der Figur wird die Erfindung näher erläutert.

Die FIG zeigt einen Prüfaufbau nach der Erfindung.

Filmmontierte Schaltkreise zeichnen sich dadurch aus, daß ihre Schaltkreisstruktur zusammen mit der Spider auf einen Film aufgebracht ist. Zum leichteren Transportieren oder auch für Prüfzwecke wird dieser Baustein in einem Diarahmen 11 über Haltenasen 12, die in die Filmperforierung eingreifen, gehalten.

Die Prüfung derartiger Bausteine erfolgt über eine nicht dargestellte Prüfvorrichtung, die eine Prüfanschlußplatte 2 aufweist, die aus einer Mehrlagenleiterplatte besteht, und die für Kontaktierungszwecke gefederte Kontaktnadeln 10 besitzt.

Eine unmittelbare Kontaktierung dieser Kontaktnadeln mit den Bausteinanschlüssen 1 (Spider) des Bausteins (8) ist jedoch wegen der unterschiedlichen Rasterung der Bausteinanschlüsse 1 und der Kontaktnadeln 10 auf der Prüfanschlußplatte nicht möglich. Eine Verkleinerung des Rasterabstands auf der Prüfanschlußplatte würde jedoch bei dem komplizierten Aufbau dieser Prüfanschlußplatte (Loadboard) zu einer Erschwerung der Herstellung derartiger Prüfanschlußplatten führen.

Durch das Einfügen der Zwischenleiterplatte 4 wird dieser Nachteil vermieden. Dabei ist die Zwischenleiterplatte 4 ebenfalls eine Mehrlagenleiterplatte, bei der zumindest auf ihrer Unterseite sich vom Zentrum zur Peripherie hin auffächernde Leiterbahnen vorgesehen sind, wobei die Rasterung im Zentrum der Rasterung der Bausteinanschlüsse (Spider) und die Rasterung an der Peripherie der Rasterung der federnden Nadelkontakte 10 der Prüfanschlußplatte 2 entspricht. An den Leiterbahnenden im Zentrum der Zwischenleiterplatte 4 sitzen nichtfedernde Kontaktnadeln 6, die den Kontakt zwischen den auf der Unterseite der Zwischenleiterplatte 4 befindlichen Leiterbahnen und den auf der Oberseite der Zwischenleiterplatte aufliegenden Bausteinanschlüssen 1 herstellen. Auf die Bausteinanschlüsse 1 drücken außerdem von oben her Federstempel 7, so daß eine lösbare Kontaktierung zwischen der Zwischenleiterplatte 4 und dem zu prüfenden Baustein 8 entsteht. An der Unterseite des Bausteins ist die Kühlvorrichtung 9 angeordnet. Aus der Querschnittszeichnung ist deutlich ersichtlich, daß der Rasterabstand der feststehenden Kontaktnadeln 6 der Zwischenleiterplatte 4 wesentlich kleiner ist als der Rasterabstand der gefederten Kontaktnadeln 10 auf der Prüfanschlußplatte.

## Patentansprüche

1. Adaptiervorrichtung mit einer eine Prüfanschlußplatte (2) mit gefederten Kontaktnadeln (10) enthaltenden Prüfeinrichtung und mit auf einem Film aufgebrachten, zu prüfenden integrierten Bausteinen, **dadurch gekennzeichnet**, daß zur Adaptierung der Bausteine (8) mit der Prüfanschlußplatte (2) der Prüfeinrichtung eine Zwischenleiterplatte (4) mit vom Zentrum dieser Zwischenleiterplatte (4) auffächernd nach außen verlaufenden Leiterbahnen vorhanden ist, wobei die Rasterabstände im Zentrum der Zwischenleiterplatte (4) den Rasterabständen der Bausteinanschlüsse (1) und die Rasterabstände an der Peripherie der Zwischenleiterplatte (4) den Rasterabständen der Anschlüsse auf der Prüfanschlußplatte (2) entsprechen, daß die Leiterbahnenden im Zentrum der Zwischenleiterplatte (4) feststehende, die Zwischenleiterplatte durchdringende Kontaktnadeln (6) aufweisen, daß die Bausteinanschlüsse (1) mit Hilfe von gefederten Stempeln (7) an die feststehenden Kontaktnadeln (6) andrückbar sind, und die gefederten Kontaktnadeln (10) der Prüfanschlußplatte (2) die Kontaktstellen an der Peripherie der Zwischenleiterplattenunterseite kontaktieren.

2. Adaptiervorrichtung nach Anspruch 1, **dadurch gekennzeichnet**, daß die integrierten Bausteine (8) auf dem Rücken liegend mit der Zwischenleiterplatte (4) kontaktiert sind und unterhalb der Bausteine (8) eine Kühleinrichtung (9) vorgesehen ist.

## Claims

1. Adaptation facility having a test device which contains a test connection board (2) with sprung contact needles (10), and having integrated components which are applied to a film and are to be tested, characterized in that for adapting the components (8) to the test connection board (2) of the test device an intermediate printed circuit board (4) is available which has conductor tracks which fan out from the centre of this intermediate printed circuit board (4), the grid spacings in the centre of the intermediate printed circuit board (4) corresponding to the grid spacings of the component connections (1) and the grid spacings on the periphery of the intermediate printed circuit board (4) corresponding to the grid spacings of the connections on the test connection board (2), in that the conductor track ends have contact needles (6) which are fixed at the centre of the intermediate printed circuit board (4) and penetrate the intermediate printed circuit board, in that the component connections (1) can be pressed against the fixed contact needles (6) by means of sprung plungers (7), and the sprung contact needles (10) of the test connection board (2) make contact with the contact points on the periphery of the underside of the intermediate printed circuit board.

2. Adaptation facility according to Claim 1, characterized in that the integrated components (8), lying on the back, make contact with the intermediate printed circuit board (4) and a cooling device (9) is provided below the components (8).

## Revendications

1. Adaptateur comportant un dispositif de contrôle, qui comporte une plaque de raccordement de contrôle (2) pourvue d'aiguilles de contact (10) suspendues élastiquement, et des modules intégrés devant être contrôlés, qui sont montés sur une pellicule, caractérisé par le fait que pour l'adaptation des modules (8) à la plaque de raccordement de contrôle (2) du dispositif de contrôle, il est prévu une plaque à circuits imprimés intermédiaire (4) comportant des voies conductrices qui s'étendent vers l'extérieur en éventail à partir du centre de cette plaque (4) à circuits imprimés intermédiaire (4), les pas au centre de la plaquette à circuits imprimés intermédiaire (4) correspondant aux pas des bornes (1) des modules, tandis que les pas situés à la périphérie de la plaquette à circuits imprimés intermédiaires (4) correspondent aux pas des bornes sur la plaque de raccordement de contrôle (2), que les extrémités des voies conductrices possèdent des aiguilles de contact (6) qui sont perpendiculaires au centre de la plaquette à circuits imprimés intermédiaire (4) et traversent cette plaquette, que les bornes (1) des modules peuvent être repoussées, à l'aide de poinçons (7) suspendus élastiquement, contre les aiguilles fixes de contact (6), et que les aiguilles de contact suspendues (10) de la plaque de raccordement de contrôle (2) touchent les points de contact situés sur la périphérie de la face inférieure de la plaquette à circuits imprimés intermédiaire.

2. Adaptateur suivant la revendication 1, caractérisé par le fait que les modules intégrés (8) touchent la plaquette à circuits imprimés intermédiaire (4) en étant couchés sur le dos, et un dispositif de refroidissement (9) est prévu au-dessous des modules (8).
